# EUROPEAN PATENT SPECIFICATION

(11) **EP 0 999 918 B1**
(45) Date of publication and mention of the grant of the patent: **11.12.2002**
(21) Application number: 98935180.4
(22) Date of filing: 21.07.1998
(51) Int. Cl.: B24D 11/06, B24B 37/04, B24B 21/04

(54) **POLISHING SEMICONDUCTOR WAFERS**
POLIEREN VON HALBLEITERSCHEIBEN
POLISSAGE DE PLAQUETTES EN SEMICONDUCTEUR

(30) Priority: 30.07.1997 US 903004; 30.09.1997 US 941386
(43) Date of publication of application: 17.05.2000
(73) Proprietor: Peripheral Products Inc, Salem, New Hampshire 030709 (US)
(72) Inventor: DUDOVICZ, Walter, Salem, NH 03276 (US); LOMBARDO, Brian, Amherst, NH 03031 (US); CONKLIN, Alfred A., Plymouth, New Hampshire 03264-3513 (US)
(74) Representative: Middlemist, Ian Alastair
(86) International application number: PCT/GB98/02174
(87) International publication number: WO 99/006182

(56) References cited:
- EP-A- 0 696 495
- WO-A-98/35785
- US-A- 5 482 756
- PATENT ABSTRACTS OF JAPAN vol. 013, no. 065 (M-797), 14 February 1989 -& JP 63 267155 A (BABCOCK HITACHI KK), 4 November 1988

## Description

This invention relates to apparatus for polishing silicon or semiconductor wafers.

### Background of the Invention

Silicon wafers are produced as precursors from which microelectronic semiconductor components are produced. The wafers are cleaved from cylindrical silicon crystals, parallel to their major surfaces, analogous to the cleavage of slate, to produce thin disks, typically 20 - 30 cm in diameter. The resulting wafers require to be polished to give totally flat and planar surfaces for deposition of electronic components onto the surface by standard lithographic and etching techniques to form integrated chip semiconductor devices. Typically a 20 cm diameter wafer will produce about 40 microprocessor chips.

The designed size of such integrated chips is steadily decreasing and' the number of layers applied, e. g. by lithography onto the silicon surface is rising, to produce ever smaller and increasingly complex microcircuits. Present semiconductors typically incorporate 3 or 4 metal layers, whilst it is expected that future designs will contain 5 or more layers. The decrease in the size of circuitry and the increase in the number of layers applied are leading to ever more stringent requirements on the smoothness and planarity of the silicon and semiconductor wafers throughout the chip manufacturing process, since uneven surfaces ultimately result in imperfections and defects, leading to unplanned resistances where a conductor is narrowed, to capacitances / nonconductive gaps where breaks occur in deposited conductor layers, and to unplanned short circuits where insulating barriers are breached, which interfere with or compromise the planned operation of the circuit.

The standard wafer polishing technique in use at present is to remove a wafer from a stack, or cassette of e. g. 10 wafers, by means of a robotic arm, and manoeuvre the wafer into position over a rotating flat polishing pad mounted on a large turntable. The polishing pad is usually made of polyurethane foam, a polishing slurry is usually applied to the surface of the pad, and the wafer is held in place by an overhead platen whilst being polished by the rotating pad and slurry. This is an adaptation of optical polishing technology used for polishing lenses, mirrors, and other optical components. Once polishing is completed, the robot arm removes the wafer and transfers it to another work station for eventual lithographic deposition and etch steps.

A significantly different approach is so-called Linear Planarisation Technology (LPT), developed by OnTrak, wherein an endless traveling belt is used to polish the wafer, in place of the rotating flat turntable form of polishing tool. The belt used in this method is described in EP-A-0696495 and comprises an endless belt of sheet steel or other high strength material, having a conventional flat polyurethane polishing pad affixed to it with adhesive. The major problems with this two-piece arrangement include the difficulties in properly mounting, maintaining, and removing the polishing pads. For example improper mounting can result in high spots or blisters caused by air trapped between the pad and the metal belt, poor adhesion can result in delamination of the pad material during use, and improperly prepared seams in the pad surface can result in ragged, abrasive edges. Proper mounting is time consuming and tedious, and improper mounting can lead to costly damage to valuable wafers and process downtime. Another problem with the two-piece belt arrangement is the potential for metal dust from the supporting belt and for abrasive particles from the adhesive to contaminate or scratch the surface of the wafer.

### Objects of the Invention

An object of the present invention is to provide a one-piece belt with a seamless polishing surface for polishing silicon and semiconductor wafers wherein the problems arising from the use of a two-piece sheet metal belt having a flat polishing pad bonded to it, are at least substantially overcome.

### Summary of the Invention

This invention provides for use in polishing silicon and semiconductor wafers, a one-piece endless belt to act as a polishing tool, characterised in that the belt comprises a supporting woven or non-woven fabric coated or impregnated with a suitable polymer, which at least forms a seamless polishing surface.

The polymer is preferably polyurethane. Alternatively the polymer may be any thermoset or thermoplastic polymer, copolymer, or blend having desired properties such as sufficient flexibility, abrasion resistance, and water and chemical resistance. Examples of possible polymers include but are not limited to polyureas, polyamides, polyesters, polycarbonates, polyethers, polyacrylates, polymethacrylates, substituted vinyl polymers, polyacrylamide, polyacrylonitrile, polyketones, silicones, saturated and unsaturated polymeric hydrocarbons, fluoropolymers, and epoxy resins.

The polymer may be solid, or it may be porous or foamed. Porous or foamed polymer may be formed by any suitable method including but not limited to blowing, frothing, leaching, coagulation, or inclusion of porous or hollow particles or microelements. The polymer may contain any desired fillers or abrasives or encapsulated materials. The polymer may be any desired hardness or have any desired rigidity or other properties. The polymer may be formed by any suitable method including but not limited to hot casting, thermoforming, or partially fusing fine particles as in sintering. The polymer may be transparent, translucent, or opaque.

The fabric may be a substrate which is woven in endless form embodying yarns and fibers of any suitable composition and properties to properly support the polishing belt in a given application. Typically yarns of high tensile strength and relatively low elongation are most suitable to give stability and durability during use, for example, on the LPT machines developed by OnTrak.

A fabric woven in endless form lacks the weak spots of a seam or splice, which is a great advantage as these belts typically operate under extremely high tension to prevent the formation of ripples or wrinkles. The fabric may have any suitable weave pattern.

Examples of suitable yarns are meta- or para- aramids such as KEVLAR, NOMEX, or TWARON; PBO or its derivatives; polyetherimide; polyimide; polyetherketone; PEEK; gel-spun UHMW polyethylene (such as DYNEEMA or SPECTRA); or polybenzimidazole; or other yarns commonly used in high-performance fabrics such as those for making aerospace parts. Mixtures or blends of any two or more yarns may be used, as may glass fibres (preferably sized), carbon, or metal, or ceramic yarns including basalt or other rock fibres, or mixtures of such elemental or mineral fibres with natural or synthetic organic polymer yarns, such as cotton, nylon, or polyester. Glass, ceramic, and metal fibers are acceptable for use in this invention as long as they are fully encapsulated by the polymer, and thus do not pose a threat to the integrity or to the quality of the wafer being polished. Most preferred are aramid yarns due to their low weight and high strength. However yarns of lower strength and higher elongation may be used, although these may only be suitable in applications where belt mounting tensions are lower.

A non woven fabric substrate may be provided in place of a woven substrate and be formed from any one, or a blend or mixture of any of the above mentioned yarns or fibres. More than one non woven substrate may be provided, preferably two, and they may be vertically aligned or offset relative to one another.

A belt substrate may comprise a non-woven fabric with additional spaced apart linear yarns extending substantially in a common direction, and a polymeric matrix material interconnecting and at least partially encapsulating each of the yarns. The linear yarns preferably are oriented in the running direction of the belt, but may also or instead be oriented in the cross-machine direction, i. e., transversely of the belt e. g., as described in GB-A-2202873. Extra reinforcing yarns extending substantially in the machine direction may also be provided.

The belt substrate may have a relatively high open area in order to increase delamination resistance, where the substrate is more fully impregnated with polymer. For this, a spiral link belt of the kind disclosed in GB-A-2051154, comprising an array of, e. g., cross-machine direction hinge wires, connected by interdigitating flattened helical coils is particularly preferred, as one type of large open area woven fabrics This substrate may support a woven or non-woven fabric which is coated or partially or fully impregnated with the suitable polymer.

The belt may comprise any number of polymer and fabric layers, in any desired sequence. Multiple supporting fabric layers can be the same or different composition, construction, and orientation. Multiple polymer layers can be of different composition, construction, and properties, including combinations of solid and porous layers, combinations of hard and soft layers, and combinations of filled and unfilled layers. For example, the belt may comprise two or more polymer layers of different hardnesses above the supporting fabric layer. The upper layer may be the harder layer, or on the other hand the lower layer may be the harder layer. Either the upper layer or the lower layer may comprise a foamed polymer, or be formed of or incorporate hollow microelements which form pores in the polymer layer. The belt may comprise at least one layer of partially fused polymeric particles, or two or more thermoplastic polymers of different melting points. Abrasive particles or fibres may be added to the upper layer.

In addition, the polishing and tracking surfaces of the belt may have micro or macro texturing, grooves, or discontinuities. The surface may have areas of hard and soft polymer, may have areas of transparent and opaque material, or may have areas of raised and lowered features. The belt may have holes that extend completely through the belt from top surface to bottom surface. The surface of the belt may be formed with grooves extending in the running direction of the belt to distribute and remove wet slurry and abraded particles generated during the polishing process and to reduce hydroplaning for more consistent contact between the belt and the wafer. Slurry can be removed from the belt grooves using any suitable method, including but not limited to the use of one or more high pressure water jets, rotating fine brushes or hard non-metallic (e. g. ceramic) stylii.

### Description of Drawings

Fig. 1 is a diagram of a continuous belt-type apparatus for polishing silicon wafers, of the kind incorporating a belt in accordance with the invention;
Fig. 2 is a fragmentary enlarged diagrammatic cross-section taken across the machine direction of one embodiment of polishing belt of the invention;
Fig. 3 is a view similar to Fig. 2 of another embodiment of the belt of the invention;
Fig. 4 is a view similar to Figs. 2 and 3 of yet another embodiment of the belt according to the invention;
Fig. 5 is a similar view of a fourth embodiment of the belt according to the invention;
Fig. 6 is a similar view of a fifth embodiment of belt according to the invention;
Fig. 7 is a similar view of a sixth embodiment of belt according to the invention;
Fig. 8 is a similar view of a seventh embodiment of belt according to the invention;
Fig. 9 is a similar view of an eighth embodiment of belt according to the invention;
Fig. 10 is a similar view of a ninth embodiment of belt according to the invention; and
Fig. 11 is a similar view of a tenth embodiment of belt according to the invention.

### Description of Exemplified Embodiments

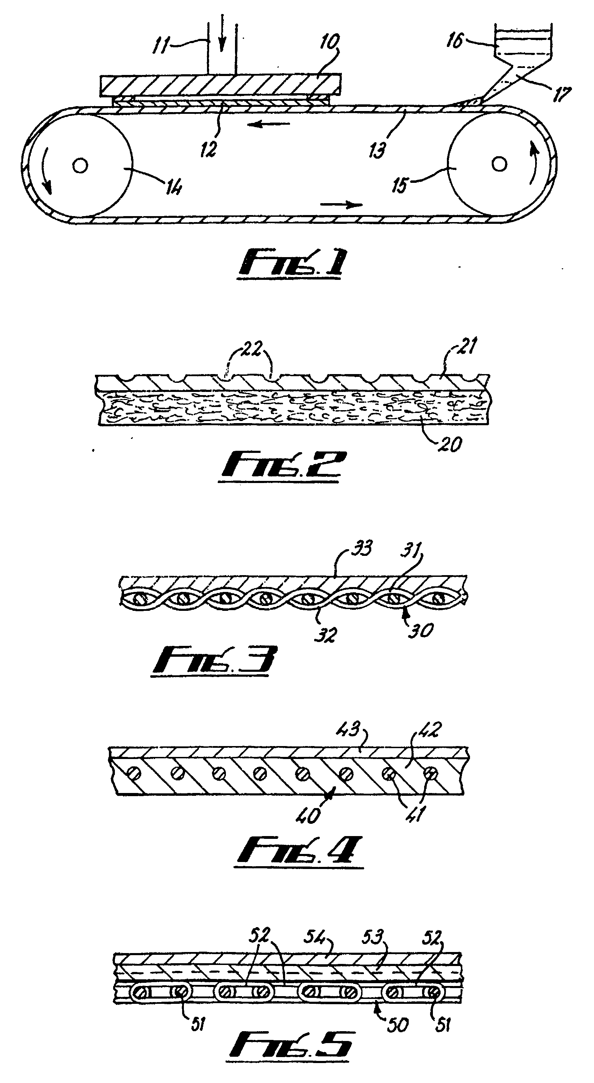

Fig. 1 is a diagrammatic view of a continuous belt machine for polishing and planarising silicon and semiconductor wafers. A platen 10 operable by a hydraulic or pneumatic ram 11, holds a silicon wafer 12 flat on the surface of a continuous belt 13, after the wafer 12 has been put in place by a remotely controlled or autonomous handling system such as a robotic arm (not shown). Belt 13 is passed around end rollers 14, 15 and is driven in the sense indicated by the arrows on the drawing. A polishing slurry, containing very fine grade abrasive is fed onto the upper surface of the belt from a reservoir 16, through a feeder 17. An example of a suitable polishing slurry is disclosed in WO 96/16436 by Advanced Micro Devices, Inc. The feeder 17 may be associated with means known in the prior art for achieving the desired distribution of the slurry on the belt, prior to encountering the wafer 12 which is to be polished by the chemical-mechanical polishing process.

Polishing is achieved by the motion of the belt 13 in contact with the surface of the wafer 12 which is to be polished, in forced contact under pressure with the wafer surface, from the platen 10 and ram 11. In accordance with the invention the belt 13 is made from a supporting substrate at least coated with a suitable polymeric material, and some possible structures are illustrated in the following figures by way of example.

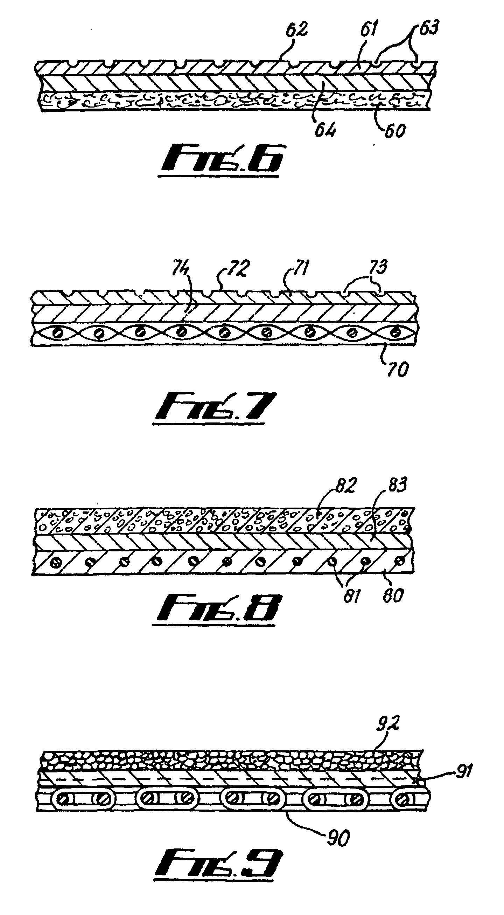

In Fig. 2 a non-woven fibrous batt 20, preferably impregnated and reinforced with a suitable resin, is coated on its upper surface, for contacting wafers to be polished, with a layer 21 of solid polyurethane. The upper surface is formed with a multitude of parallel machine-direction grooves 22 for drainage of the used slurry (comprising abrasive particles, liquid medium and particles removed from the surface of the wafer) from the polishing site.

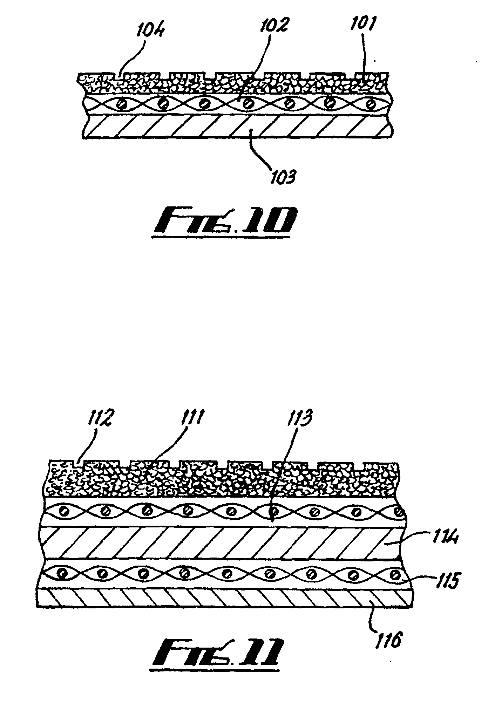

In Fig. 3 a woven substrate 30 is shown, comprising machine direction yarns 31, with cross-machine direction yarns 32 interwoven through them. The simplest possible weave pattern is shown, but of course more complex weave patterns, including multitier MD yarns 31 may be used, to obtain a bulkier woven substrate. Multiple layers of woven substrate 30 may be overlaid and impregnated with a binder or resin if desired. The yarns 32 may run in the cross-machine direction with the interwoven yarns 31 extending in the machine direction. The substrate 30 is coated on its upper polishing surface with a layer 33 of polyurethane. This preferably strikes into the woven substrate, and may impregnate the substrate completely, fully encapsulating the supporting fabric on all sides and edges, although this is not explicitly shown by the drawing.

In Fig. 4 a non-woven substrate 40 comprises an array of yarns 41, extending e.g. in the machine direction, encapsulated in a polymeric material matrix 42. A coating 43 of a polyurethane is provided on the polishing surface of the substrate 40. The substrate may be of the kind described in GB-A-2202873 and may include vertical passages through the substrate as disclosed in that specification.

In Fig. 5 a substrate 50 is provided which comprises a link belt of the kind disclosed in GB-A-2051154. This has an array of cross-machine direction hinge wires 51, each pair of which are connected by respective flattened helical coils 52, which each interdigitate with the adjacent coils about the respective hinge wires. Substrate 50 is covered with a fibrous layer, such as a non woven, plastics impregnated, and reinforced batt 53, which is in turn coated with a layer 54 of polymer. The hinge wires 51 and helical wires 52 may be of a suitable polyamide material or less preferably of metal wire or other high strength material.

Fig. 6 illustrates another embodiment of belt which comprises a supporting substrate 60, and two layers of different hardness materials. These comprise an upper layer 61 of a relatively hard material, such as polyurethane with 40 - 90 Shore D hardness. Layer 61 provides an upper surface 62 which is formed with parallel machine direction grooves 63 for drainage of used slurry from the polishing site. A second, intermediate layer 64 is sandwiched between the relatively hard upper layer 61 and the substrate 60 and comprises a relatively soft material such as 10 - 80 Shore A hardness polyurethane. The substrate 60 comprises, as in Fig. 2 a non woven fibrous batt which is impregnated and reinforced with a suitable resin.

The structure superposing a relatively hard top surface material over a relatively soft layer combines the benefits of a hard outer surface 62 with the resilience of the softer layer 64, allowing for superior local and global planarization of the wafer; the rigid top layer resists conforming to local peaks and valleys while the compressible lower layer allows for broader scale conformance for more even, parallel contact between the polishing surface and the wafer.

Fig. 7 illustrates a further embodiment of belt which comprises a woven supporting substrate 70, carrying an upper layer 71 of a relatively soft material, such as 10 - 80 Shore A hardness polyurethane, providing an upper surface 72 with drainage grooves 73, and an intermediate sandwiched layer 74 of a relatively hard material, such as 40 - 90 Shore D hardness polyurethane. This arrangement is essentially the reverse of that of Fig. 6, but gives a compliant top surface, which can be desired in some polishing applications, and a hard middle layer, which provides greater stiffness to the belt.

Fig. 8 shows another embodiment of belt according to the invention, comprising a supporting substrate 80 in the form of membrane having machine direction reinforcing yarns 81 embedded therein. The membrane 80 may be perforated, although this is not shown. Membrane substrate 80 carries an upper layer 82 of foamed plastics material, e.g. polyurethane, polyethylene, polytetrafluoroethylene, styrene, etc. This foam may be rigid or preferably flexible, and provides surface porosity to help distribute slurry, to reduce hydroplaning of the wafer over the belt, and to aid in removal of abraded particles. The necessary stiffness to hold the wafer in place is provided by an intermediate layer of harder, e.g. 40 - 90 Shore D hardness polyurethane 83. The two polymer layers may have the same or very different thicknesses depending on the intended properties of the belt.

Fig. 9 shows a yet further embodiment of belt comprising a spiral link fabric substrate 90, carrying an intermediate relatively hard layer 91, of e.g. 40 - 90 Shore D hardness polyurethane, carrying an upper layer 92 of polyurethane containing hollow beads to form pores in the polishing surface, similar to a foam coating. Preferred beads are hollow plastic spheres, such as Expancel 551 DE, available from Akzo Nobel, that are made especially for conveniently adding porosity to polymers like polyurethane.

Fig. 10 shows a grooved belt in accordance with the invention with an endless woven support fabric (102) coated on top with a polyurethane layer (101) containing hollow microelements to create porosity and coated on the bottom with a solid polyurethane layer (103). The supporting fabric is integrally bonded and impregnated by the surrounding polymer layers, although the drawing does not explicitly show it. All sides and edges of the fabric are completely encapsulated by the polymer layers, which reduces the likelihood of dust or particles from the fabric interfering with the polishing process, and which prevents the direct contact between fabric and slurry, that could potentially weaken the belt or negatively affect the performance of the belt. The polymer layers can be any desired hardnesses. The conventional wisdom is that higher hardness gives better planarization, and softer materials give higher removal rates. Although state of the art polishing pads are made from polyurethane that cures to about 75 Shore D in solid, non-porous form, this invention, including the belt in this specific example, may comprise any suitable or desired polymeric materials of any suitable or desired hardness.

Note that this type of construction with the fabric in the middle of the belt helps it to lie flat and resist curling up at the edges when mounted on rollers. Another way to minimize or eliminate the tendency of the edges of the belt to curl up or down is to use a reinforcing substrate that has a relatively high open area.

Figure 11 shows a grooved (112) multilayer belt with a porous polymer layer (111) on top and a solid polymer layer (116) on bottom. The middle layers of the belt include two woven fabric layers (113, 115) with a soft urethane layer (114) in between. The advantage of this type of construction is that the overall strength of the belt is increased while providing a cushion layer between the two layers of fabric. Also this belt may allow higher mounting tensions to be used without transferring uneven stresses to the polishing surface, especially during steering of the rollers to control tracking.

The upper layer in any of the described embodiments may comprise at least one layer of partially fused polymer particles, and/or comprise two or more thermoplastic polymers having different melting points. The sintered layer may optionally be reinforced by a textile material, e.g. a membrane, woven, or nonwoven fabric, or chopped fibres. The polymer layers may incorporate hollow microbeads of plastics, glass, or soluble material (such as CMC) which may later break down to provide a porous surface. Glass beads can be used for their abrasive properties. The hollow beads may contain additional materials like lubricants, abrasives, pH buffers, indicators, etc. The hollow beads may be cut open when the cured belt is conditioned e.g. by grinding, providing location on the belt surface which can retain slurry or release materials from inside the microelements.

Abrasive particles or fibres, such as TiO2; CeO2; SiC; Si3N4; Al2O3; glass; silicates; BaC03; CaC03; diamond or carbon may be added to the upper layer, which may also or instead consist of a transparent coating.

The surface of the upper layer may be provided with a micro textured coating, that is with micro-scale grooves or roughness, formed for example by machining, laser cutting (preferably with an ablation or excimer laser), or chemical means (e.g. by dissolving soluble particles such as sugar or cooking salt present in the upper layer).

Any of the various substrates illustrated may be used in combination with any of the single layer, double layer, or multilayer structures described or implied. It will be obvious to those skilled in the art that many other combinations of layers, not described here, are possible.

In the above embodiments the substrate fabric 20, 30, or cover layer 53 may be an endless woven material to avoid the weakness imported by a splice or seam. The fabric may be woven from yarns of a high tensile strength and relatively low elongation, such as meta- or para- aramids, e.g. KEVLAR, NOMEX, or TWARON; as well as PBO or its derivatives; polyetherimide, polyetherketone, PEEK, gel-spun UHMW polyethylene (e.g. DYNEEMA or SPECTRA); or polybenzimidazole. Yarns of these compositions may be mixed or blended and metal or mineral fibres such as glass, carbon, or ceramic yarns including rock fibers (e.g. basalt) on there own or mixed or blended with natural or synthetic polymer yarns may be used. The aramids are preferred on account of their low weight and high strength. However any other suitable type of fiber, including various nylons, polyesters, and other types not named here may be used. Suitability depends on the specific application and operating tensions.

The polymer coating may also be any suitable thermoplastic or thermoset materials, copolymers, mixtures, or blends with the desired properties, such as abrasion resistance, hardness, and moisture resistance. Possible materials include but are not limited to polymers chosen from the group of polyurethanes, polyureas, polyamides, polyesters, polycarbonates, polyethers, polyacrylates, polymethacrylates, substituted vinyl polymers, polyacrylamide, polyacrylonitrile, polyketones, silicones, saturated and unsaturated polymeric hydrocarbons, fluoropolymers, and epoxy resins.

Woven metal mesh and perforate metal sheet belt substrate may be used with the belt interstices being occupied by rivets or fillers of polymeric material, improving bond strength between the polymer and metal. The metal would typically be fully encapsulated by polymer to avoid potential contamination of the wafer during polishing.

The main advantages of a chemical-mechanical polishing belt according to the invention are that a one-piece, integrated belt with a seamless polishing surface is provided with significantly improved ease of use, improving operating efficiency and consistency and reducing the potential for damaging valuable semiconductor wafers. The present invention requires less effort to mount and to change the polishing substrate, and it significantly reduces the chance of wafer damage from improperly mounted pads, ragged seams, and delamination compared to the two-piece arrangement described in EP-A-0696495.

The belt is typically 1.5 - 4 meters in length, measured as the inner circumference of the endless belt, 0.1 - 0.6 meters in width, and 0.1 - 0.6 cm thick. The coating typically comprises 10 - 90% of the thickness. However the invention is not limited to these dimensions.

Belts according to this invention can be used to polish any type material or layer in any of various polishing steps in semiconductor manufacturing. Typical materials to be polished include but are not limited to silicon, silicon dioxide, copper, tungsten, and aluminum. The polishing belt may be designed to selectively polish some materials and not others, to polish dissimilar materials at similar rates, or to work specifically with certain specific types of slurries and solutions. A belt according to the invention may be applicable in other industries, for example for polishing and planarizing optical flats and mirrors.

## Claims

1. For use in polishing silicon and semiconductor wafers, an endless belt to act as a polishing tool, **characterised in that** said belt comprises a woven or non-woven fabric coated with a suitable polymer to form a seamless polishing surface.

2. A belt according to Claim 1, wherein at least the top layer of the belt comprises a porous or foam polymer.

3. A belt according to Claim 2, wherein the porous structure is attained by the use of hollow microelements.

4. A belt according to Claim 2, wherein the top layer of the belt comprises porous polyurethane.

5. A belt according to Claim 4, wherein the nominal Shore D hardness of the polyurethane when cured in its solid, non-porous form is in the range 40 - 90.

6. A belt according to Claim 1, wherein there is at least a substantial polymer layer both above and below the supporting fabric.

7. A belt according to Claim 6, wherein the top layer above the fabric is porous and the bottom layer below the fabric is solid or non-porous.

8. A belt according to Claim 1, wherein at least one of the polymer layers comprises a thermoset or thermoplastic polymer, copolymer, or blend with high abrasion resistance.

9. A belt according to Claim 8, wherein the polymers are chosen from the group of polyurethanes, polyureas, polyamides, polyesters, polycarbonates, polyethers, polyacrylates, polymethacrylates, substituted vinyl polymers, polyacrylamide, polyacrylonitrile, and polyketones.

10. A belt according to Claim 1, wherein at least one of the polymer layers comprises a thermoset or thermoplastic polymer, copolymer, or blend with high chemical or moisture resistance.

11. A belt according to Claim 10, wherein the polymers are chosen from the group of silicones, saturated and unsaturated polymeric hydrocarbons, fluoropolymers, and epoxy resins.

12. A belt according to Claim 1, wherein there are two polymer layers, a top layer and an intermediate layer, above the supporting fabric.

13. A belt according to Claim 12, wherein the top polymer layer is harder than the intermediate layer.

14. A belt according to Claim 12, wherein the top polymer layer is softer than the intermediate layer.

15. A belt according to Claim 12, wherein the top polymer layer is porous and the intermediate layer is non-porous.

16. A belt according to Claim 12, wherein both the top layer and the intermediate layer are porous.

17. A belt according to Claim 1, wherein the top layer comprises abrasive particles or fibers.

18. A belt according to Claim 1, wherein the top layer of the belt has a microtexture or macrotexture on the surface.

19. A belt according to Claim 18, wherein the microtexture or macrotexture is continuously renewed by chemical or mechanical means while the polishing belt is in operation.

20. A belt according to Claim 18, wherein the macrotexturing comprises grooves running generally in the machine direction of the belt.

21. A belt according to Claim 20, wherein the grooves are formed by a single continuous spiral around the circumference of the belt.

22. A belt according to Claim 1, wherein there are holes that pass through the belt from top to bottom.

23. A belt according to Claim 1, wherein there is at least one portion of the belt that transparent to electromagnetic waves that are useful in taking measurements of the wafer through the belt while polishing is in operation.

24. A belt according to Claim 23, wherein at least one portion of the belt is transparent to visible light, ultraviolet light, or x-rays.

25. A belt according to Claim 1, wherein the top layer of the belt comprises more than one polymeric material with different hardnesses.

26. A belt according to claim 1, wherein said fabric is woven in endless form and embodies yarns of high tensile strength and low elongation.

27. A belt according to claim 26, wherein said high tensile strength yarns are selected from the group comprising: meta- or para-aramids; polyetherimide; polyimide; polyetherketone; PEEK; gel spun UHMW polyethylene; and polybenzimidazole.

28. A belt according to claim 26, wherein said high tensile strength yarns comprise a mixture or blend of two or more such yarns.

29. A belt according to claim 26, wherein said yarns are of any one of: - glass fibers, carbon or ceramic yarns, basalt fibers, other rock fibers, or mixtures of mineral fibers with natural or synthetic polymer yarns.

30. A belt according to claim 26, wherein natural yarns such as cotton are woven in the transverse direction, across the width of the belt.

31. A belt according to claim 1, wherein said fabric is a non woven fabric formed from one or more staple yarns.

32. A belt according to claim 31, wherein said yarn staple comprises one or more groups of fibers selected from the group comprising: - meta or para aramids; polyetherimide, polyimide; polyetherketone; PEEK; gel-spun UHMW polyethylene; polybenzimidazole; glass fibers; carbon fibers; ceramic fibers; basalt fibers; other rock fibers; and metal fibers.

33. A belt according to claim 1, wherein said fabric comprises a non woven fabric incorporating additional spaced apart linear yarns extending substantially in a common direction and a polymeric matrix material interconnecting and at least partially encapsulating each said yarn.

34. A belt according to claim 33, wherein said linear yarns are oriented in the running direction of said belt.

35. A belt according to claim 33, wherein said linear yarns are oriented transversely of said belt.

36. A belt according to claim 35, wherein additional reinforcing yarns are provided extending in the running direction of said belt.

37. A belt according to claim 1, wherein said supporting substrate has a relatively high open area.

38. A belt according to claim 37, wherein said belt includes a spiral-link supporting substrate.

39. A belt according to claim 38, wherein said spiral-link belt supports a woven or non woven fabric layer which is coated or impregnated with said polymer.

## Patentansprüche

1. Endlosband zur Verwendung als Polierwerkzeug zum Polieren von Silicium- und Halbleiter-Wafern,
**dadurch gekennzeichnet, daß** das Band ein Gewebe oder ein Faservlies umfaßt, das zur Bildung einer verbindungsnahtfreien Polieroberfläche mit einem geeigneten Polymer beschichtet ist.

2. Band nach Anspruch 1,
bei dem zumindest die obere Schicht des Bandes ein poröses oder Schaumpolymer umfaßt.

3. Band nach Anspruch 2,
bei dem die poröse Struktur durch Verwendung von hohlen Mikroelementen erzielt wird.

4. Band nach Anspruch 2,
bei dem die obere Schicht des Bandes poröses Polyurethan umfaßt.

5. Band nach Anspruch 4,
bei dem die nominelle Shore-D-Härte des Polyurethans, wenn es in seiner festen, nichtporösen Form aushärtet, im Bereich von 40 bis 90 liegt.

6. Band nach Anspruch 1,
bei dem sowohl über als auch unter dem Stützgewebe zumindest eine stabile Polymerschicht vorhanden ist.

7. Band nach Anspruch 6,
bei dem die obere Schicht über dem Gewebe porös und die untere Schicht unter dem Gewebe fest oder nichtporös ist.

8. Band nach Anspruch 1,
bei dem mindestens eine der polymeren Schichten ein wärmehärtbares oder thermoplastisches Polymer, Copolymer oder Gemisch von hoher Abriebfestigkeit umfaßt.

9. Band nach Anspruch 8,
bei dem die Polymere aus der Gruppe der Polyurethane, Polyharnstoffe, Polyamide, Polyester, Polycarbonate, Polyether, Polyacrylate, Polymethacrylate, substituierten Vinylpolymere, Polyacrylamid, Polyacrylnitril und Polyketone ausgewählt sind.

10. Band nach Anspruch 1,
bei dem mindestens eine der polymeren Schichten ein wärmehärtbares oder thermoplastisches Polymer, Copolymer oder Gemisch von hoher Chemikalien- oder Feuchtebeständigkeit umfaßt.

11. Band nach Anspruch 10,
bei dem die Polymere aus der Gruppe der Silikone, gesättigten und ungesättigten, polymeren Kohlenwasserstoffe, Fluorpolymere und Epoxyharze ausgewählt sind.

12. Band nach Anspruch 1,
bei dem über dem Stützgewebe zwei polymere Schichten, nämlich eine obere Schicht und eine Zwischenschicht, angeordnet sind.

13. Band nach Anspruch 12,
bei dem die obere polymere Schicht härter ist als die Zwischenschicht.

14. Band nach Anspruch 12,
bei dem die obere polymere Schicht weicher ist als die Zwischenschicht.

15. Band nach Anspruch 12,
bei dem die obere polymere Schicht porös und die Zwischenschicht nichtporös ist.

16. Band nach Anspruch 12,
bei dem sowohl die obere Schicht als auch die Zwischenschicht porös sind.

17. Band nach Anspruch 1,
bei dem die obere Schicht schleifende Partikel oder Fasern umfaßt.

18. Band nach Anspruch 1,
bei dem die obere Schicht des Bandes eine Mikrostruktur oder eine Makrostruktur auf der Oberfläche aufweist.

19. Band nach Anspruch 18,
bei dem die Mikrostruktur oder die Makrostruktur durch chemische oder mechanische Mittel ständig erneuert wird, während das Polierband in Betrieb ist.

20. Band nach Anspruch 18,
bei dem die Makrostruktur Rillen umfaßt, die sich im allgemeinen in Maschinenrichtung des Bandes erstrecken.

21. Band nach Anspruch 20,
bei dem die Rillen durch eine einzige, durchgehende Spirale gebildet sind, die sich über den Umfang des Bandes erstreckt.

22. Band nach Anspruch 1,
bei dem Löcher vorhanden sind, die sich von oben nach unten durch das Band hindurcherstrecken.

23. Band nach Anspruch 1,
bei dem zumindest ein Teil des Bandes für elektromagnetische Wellen so weit durchlässig ist, wie es zweckmäßig ist, um Messungen des Wafers durch das Band hindurch vorzunehmen, während der Poliervorgang im Gange ist.

24. Band nach Anspruch 23,
bei dem zumindest ein Teil des Bandes für sichtbares Licht, ultraviolettes Licht oder Röntgenstrahlen durchlässig ist.

25. Band nach Anspruch 1,
bei dem die obere Schicht des Bandes mehr als ein polymeres Material unterschiedlicher Härte umfaßt.

26. Band nach Anspruch 1,
bei dem das Gewebe in endloser Form gewebt ist und Fäden von hoher Zugfestigkeit und geringer Dehnung enthält.

27. Band nach Anspruch 26,
bei dem die Fäden von hoher Zugfestigkeit aus der Gruppe ausgewählt sind, die folgende Stoffe umfaßt: Meta- oder Para-Aramide; Polyetherimid; Polyimid; Polyetherketon; PEEK; aus einem Gel gesponnenes, ultrahochmolekulares Polyethylen; und Polybenzimidazol.

28. Band nach Anspruch 26,
bei dem die Fäden von hoher Zugfestigkeit eine Mischung oder ein Gemisch aus zwei oder mehreren solcher Fäden umfassen.

29. Band nach Anspruch 26,
bei dem die Fäden aus einem der folgenden Fäden bestehen: Glasfasern, Kohle- oder Keramikfäden, Basaltfasern, andere Gesteinsfasern oder Mischungen von Mineralfasern mit Fäden aus natürlichem oder synthetischem Polymer.

30. Band nach Anspruch 26,
bei dem Naturfasern, wie z. B. Baumwolle, in Querrichtung über die Breite des Bandes verwoben sind.

31. Band nach Anspruch 1,
bei dem das Gewebe ein Faservlies ist, das aus einer oder mehreren Stapelfasern gebildet ist.

32. Band nach Anspruch 31,
bei dem die Stapelfaser eine oder mehrere Gruppen von Fasern aus der Gruppe umfaßt, die umfaßt: Meta- oder Para-Aramide; Polyetherimid; Polyimid; Polyetherketon; PEEK; aus einem Gel gesponnenes, ultrahochmolekulares Polyethylen; Polybenzimidazol; Glasfasern; Kohlefasern; Keramikfasern; Basaltfasern; andere Gesteinsfasern; und Metallfasern.

33. Band nach Anspruch 1,
bei dem das Gewebe ein Faservlies umfaßt, das zusätzliche, auf Abstand liegende, lineare Fäden, die sich im wesentlichen in eine gemeinsame Richtung erstrecken, sowie ein polymeres Matrixmaterial enthält, das jeden Faden verbindet und zumindest teilweise umhüllt.

34. Band nach Anspruch 33,
bei dem die linearen Fäden in Laufrichtung des Bandes ausgerichtet sind.

35. Band nach Anspruch 33,
bei dem die linearen Fäden in Querrichtung des Bandes ausgerichtet sind.

36. Band nach Anspruch 35,
bei dem zusätzliche Verstärkungsfäden vorhanden sind, die sich in Laufrichtung des Bandes erstrecken.

37. Band nach Anspruch 1,
bei dem das Stützsubstrat einen relativ großen offenen Bereich aufweist.

38. Band nach Anspruch 37,
bei dem das Band ein Spiralglied-Stützsubstrat enthält.

39. Band nach Anspruch 38,
bei dem das Spiralglied-Band eine Schicht aus einem Gewebe oder einem Faservlies abstützt, die mit dem Polymer beschichtet oder imprägniert ist.

## Revendications

1. Courroie sans fin, destinée à être utilisée pour polir des plaquettes de silicium et à semi-conducteurs, pour agir en tant qu'outil de polissage, **caractérisée en ce que** ladite courroie comporte un tissu tissé ou non-tissé revêtu d'un polymère adapté pour former une surface de polissage sans couture.

2. Courroie selon la revendication 1, dans laquelle au moins la couche supérieure de la courroie comporte un polymère poreux ou alvéolaire.

3. Courroie selon la revendication 2, dans laquelle la structure poreuse est obtenue par utilisation de micro-éléments creux.

4. Courroie selon la revendication 2, dans laquelle la couche supérieure de la courroie comporte du polyuréthanne poreux.

5. Courroie selon la revendication 4, dans laquelle la dureté Shore D nominale du polyuréthanne, lorsqu'il est durci dans sa forme non-poreuse solide, se trouve dans la plage de 40 à 90.

6. Courroie selon la revendication 1, dans laquelle il y a au moins une couche polymère importante à la fois au-dessus et au-dessous du tissu de support.

7. Courroie selon la revendication 6, dans laquelle la couche supérieure au-dessus du tissu est poreuse et la couche inférieure au-dessous du tissu est solide ou non-poreuse.

8. Courroie selon la revendication 1, dans laquelle au moins une des couches polymères comporte un polymère thermodurci ou thermoplastique, un copolymère, ou un mélange ayant une résistance à l'abrasion élevée.

9. Courroie selon la revendication 8, dans laquelle les polymères sont choisis parmi le groupe constitué de polyuréthannes, polyurées, polyamides, polyesters, polycarbonates, polyéthers, polyacrylates, polyméthacrylates, polymères vinyliques substitués, polyacrylamide, polyacrylonitrile, et polycétones.

10. Courroie selon la revendication 1, dans laquelle au moins une des couches polymères comporte un polymère thermodurci ou thermoplastique, un copolymère, ou un mélange ayant une résistance chimique ou à l'humidité élevée.

11. Courroie selon la revendication 10, dans laquelle les polymères sont choisis parmi le groupe constitué de silicones, d'hydrocarbures polymères saturés et insaturés, de fluoropolymères, et de résines époxy.

12. Courroie selon la revendication 1, dans laquelle il y a deux couches polymères, une couche supérieure et une couche intermédiaire, au-dessus du tissu de support.

13. Courroie selon la revendication 12, dans laquelle la couche polymère supérieure est plus dure que la couche intermédiaire.

14. Courroie selon la revendication 12, dans laquelle la couche polymère supérieure est plus tendre que la couche intermédiaire.

15. Courroie selon la revendication 12, dans laquelle la couche polymère supérieure est poreuse et la couche intermédiaire est non-poreuse.

16. Courroie selon la revendication 12, dans laquelle la couche supérieure et la couche intermédiaire sont toutes deux poreuses.

17. Courroie selon la revendication 1, dans laquelle la couche supérieure comporte des particules ou des fibres abrasives.

18. Courroie selon la revendication 1, dans laquelle la couche supérieure de la courroie a une micro-texture ou une macro-texture sur la surface.

19. Courroie selon la revendication 18, dans laquelle la micro-texture ou la macro-texture est renouvelée en continu par des moyens chimiques ou mécaniques alors que la courroie de polissage est en utilisation.

20. Courroie selon la revendication 18, dans laquelle la macro-texture comporte des gorges s'étendant généralement dans la direction machine de la courroie.

21. Courroie selon la revendication 20, dans laquelle les gorges sont formées par une spirale continue unique autour de la circonférence de la courroie.

22. Courroie selon la revendication 1, dans laquelle il y a des trous qui traversent la courroie de haut en bas.

23. Courroie selon la revendication 1, dans laquelle il y a au moins une partie de la courroie qui est transparente à des ondes électromagnétiques qui sont utiles pour effectuer des mesures sur la plaquette à travers la courroie alors qu'un polissage est en cours.

24. Courroie selon la revendication 23, dans laquelle au moins une partie de la courroie est transparente à lumière visible, à lumière ultraviolette ou aux rayons X.

25. Courroie selon la revendication 1, dans laquelle la couche supérieure de la courroie comporte plus d'un matériau polymère ayant des duretés différentes.

26. Courroie selon la revendication 1, dans laquelle ledit tissu est tissé sous une forme sans fin et renferme des fils ayant une résistance à la traction élevée et un faible allongement.

27. Courroie selon la revendication 26, dans laquelle lesdits fils à résistance à la traction élevée sont sélectionnés parmi le groupe constitué de méta- ou para-aramides, polyétherimide, polyimide, polyéthercétone, PEEK, polyéthylène de poids moléculaire très élevé (UHMW) tressé en gel, et polybenzimidazole.

28. Courroie selon la revendication 26, dans laquelle lesdits fils à résistance à la traction élevée comportent un mélange ou une combinaison de deux ou plus de deux de ces fils.

29. Courroie selon la revendication 26, dans laquelle lesdits fils sont l'un quelconque des éléments suivants : des fibres de verre, des fils de carbone ou de céramique, des fibres de basalte, d'autres fibres de roche, ou des mélanges de fibres minérales avec des fils polymères naturels ou synthétiques.

30. Courroie selon la revendication 26, dans laquelle des fils naturels tels que du coton sont tissés dans la direction transversale, à travers la largeur de la courroie.

31. Courroie selon la revendication 1, dans laquelle ledit tissu est un tissu non-tissé formé à partir d'un ou plusieurs filés.

32. Courroie selon la revendication 31, dans laquelle ledit filé comporte un ou plusieurs groupes de fibres sélectionnées parmi le groupe comportant : méta- ou para-aramides, polyétherimide, polyimide, polyéthercétone, PEEK, polyéthylène UHMW tressé en gel, polybenzimidazole, fibres de verre, fibres de carbone, fibres de céramique, fibres de basalte, d'autres fibres de roche, et des fibres métalliques.

33. Courroie selon la revendication 1, dans laquelle ledit tissu comporte un tissu non-tissé comportant des fils linéaires espacés supplémentaires s'étendant essentiellement dans une direction commune et un matériau de matrice polymère interconnectant et encapsulant au moins partiellement chaque fil.

34. Courroie selon la revendication 33, dans laquelle lesdits fils linéaires sont orientés dans la direction de déplacement de ladite courroie.

35. Courroie selon la revendication 33, dans laquelle lesdits fils linéaires sont orientés transversalement à ladite courroie.

36. Courroie selon la revendication 35, dans laquelle des fils de renforcement supplémentaires sont agencés en s'étendant dans la direction de déplacement de ladite courroie.

37. Courroie selon la revendication 1, dans laquelle ledit substrat de support a une surface ouverte relativement grande.

38. Courroie selon la revendication 37, dans laquelle ladite courroie comporte un substrat de support de liaison en spirale.

39. Courroie selon la revendication 38, dans laquelle ladite courroie de liaison en spirale supporte une couche de tissu tissé ou non-tissé qui est revêtue ou imprégnée par ledit polymère.
